Europäisches Patentamt

European Patent Office

Office européen des brevets

(11) Publication number: 0 300 658
A2

# (12) EUROPEAN PATENT APPLICATION

(21) Application number: 88306303.4

(22) Date of filing: 11.07.88

(51) Int. Cl.⁴: H01L 21/00

(30) Priority: 22.07.87 US 76251

(43) Date of publication of application:
25.01.89 Bulletin 89/04

(84) Designated Contracting States:
DE FR GB

(71) Applicant: CONTROL DATA CORPORATION
8100-34th Avenue South
Minneapolis Minnesota 55440(US)

(72) Inventor: Jain, Ravindra Kumar
4301 Heritage Drive
Vadnais Heights Minnesota 55110(US)
Inventor: Spero, Payton
1400 Quebec Avenue North
Golden Valley Minnesota 55427(US)

(74) Representative: Caro, William Egerton et al
J. MILLER & CO. Lincoln House 296-302 High
Holborn
London WC1V 7JH(GB)

(54) Apparatus for and method of providing alignment to a workpiece integrated circuit package.

(57) Apparatus for providing alignment to an integrated circuit package (15) having rows of leads (16) extending therefrom has a female part (31f) having on at least one edge a plurality of teeth (62-65). A male part (31m) has on at least one edge a plurality of teeth (47-50) complementary to and inter-engaging with the teeth (62,65) of the female part (31f) when the male and female parts are engaged. Attachment means (43-46, 53-56) are provided for aligning the male and female parts whereby, in operation, co-operating teeth may hold a lead therebetween.

Fig. 5A

Fig. 5B

Fig. 5C

# APPARATUS FOR AND METHOD OF PROVIDING ALIGNMENT TO A WORKPIECE INTEGRATED CIRCUIT PACKAGE

This invention relates to apparatus for and methods of providing alignment to integrated circuit (IC) packages.

The problem of positional accuracy of leads becomes acute in areas where there are many fine leads on each side of an integrated circuit package, especially in instances where the package will be placed onto a circuit board or into a holder on a circuit board and soldered or connected there by a fixed or flexible automatic or robotic means. At the current level of technology, robotic placement of 0.64 mm (25 mil) or finer pitch leads cannot be accomplished if the leads are about 0.08 mm (3 mil) or more out of alignment. With this kind of constraint, robotic placement of integrated circuit packages with large numbers of fine leads at 0.64 mm (25 mil) or less pitch has been found to be possible in only about 5% of the manufactured integrated circuits. Vision systems have improved the placement accuracy, but they cannot correct mis-aligned leads and at the most are useful in rejecting packages with skewed leads during the placement operation.

In the production of fine leads and fine pitch integrated circuit packages, a metal frame surrounds and holds the leads in place during the construction of the integrated circuit package. Because the metal frame connects the leads, it must be severed from them prior to electrical testing of the integrated circuit at the place of manufacture. The method of holding the leads in place has to allow for hermeticity testing and other process requirements. The conventional solution to keeping the fine leads straight after excising the metal frame was to place the integrated circuit package in a plastics carrier. This carrier has ribs which have a distance of 0.25 - 0.30 mm (10 - 12 mil) between them, with a tolerance of ± 0.05 - 0.08 mm (2 - 3 mil). Clearly, such a package is unsuitable for robotic placement of integrated circuit packages. Also, the design of such carriers becomes very complicated and expensive. In spite of these exotic carriers, leads skew and damage problems still exist when the integrated circuit packages are ready to be placed on the next level of inter-connect substrate at the user assembly sites.

Another problem of integrated circuit packages which use fine leads at fine pitches, is the inability to keep the positional accuracy of the leads during transportation, handling, and bending or forming operations. A good working principle of bending or forming requires an aspect ratio of lead width to lead thickness of 1.75 or greater. Poor aspect ratio causes rotation or twisting and mis-alignment of leads during forming which results in unacceptable positional inaccuracy of leads, thus causing problems for automated placement.

Another problem which integrated circuit users (board assembly manufacturing facilities) face is the wedging entrapment of cut away lead material in forming dies. Cleaning these fine single small pieces of leads poses a big problem in maintaining the dies to provide cost effectiveness and forming accuracy.

This invention broadly seeks to provide an apparatus and method for dealing with the problem of positional accuracy of easily bendable fine pitch leads on integrated circuit packages. produces a product which has a flat, rigid, non-conductive tie bar which may form a complete frame around the package, and which holds the leads together giving required positional accuracy and rigidity. The design of the tie bar is flexible and dependent on the integrated circuit maker and user requirements.

The present invention has two aspects. Thus according to one aspect of the present invention, there is provided apparatus for providing alignment to an integrated circuit package having rows of leads extending therefrom, characterised by comprising: a female part having on at least one edge a plurality of teeth; a male part having on at least one edge a plurality of teeth complementary to and inter-engaging with the teeth of the female part when the male and female parts are engaged; and attachment means for aligning the male and female parts whereby, in operation, co-operating teeth may hold a lead therebetween.

A cavity may be provided between the male and female parts for holding the integrated circuit package when the male and female parts are engaged.

In one embodiment, the edges of the male and female parts opposite those having teeth are chamfered.

A handle may be mounted on each of the male and female parts.

There may also be provided apparatus for compressing in the plane of the rows of the leads of the integrated circuit package that portion of the lead which extends outwardly from the male and female parts of the apparatus according to the present invention characterised by comprising: a base shoulder means on which either the male or female part may rest. a first working surface on the base shoulder means so arranged and disposed to be coincident with the plane of the rows of workpiece leads when said male and female parts are mounted on said base shoulder means, a second working surface which, in operation, is arranged and disposed to meet the first working surface with portions of the leads extending beyond the male and female parts disposed therebetween, and means for applying pressure between said working surfaces to the portions of the leads extending outwardly of the male and female parts.

This apparatus is applicable to integrated circuit packages which are supplied without a metal frame supporting the leads. This can be implemented at the IC users facility if the IC vendors do not want to implement the technology.

According to another aspect of the present invention, there is provided an apparatus for mounting a tie bar to an integrated circuit package having rows of leads extending therefrom, said leads being connected at their extremities by a frame, said apparatus being characterised by comprising: a base die means having recesses therein and alignment means for locating the integrated circuit package; top means; alignment means arranged to allow movement of said top means towards or away from said base die; upper die means; knife means mounted on the top means, passing through respective apertures in said upper die means and, in operation, being received in respect of apertures in the base die means; and compression means for compressibly mounting the upper die means to the top means, the upper die means having means for receiving said alignment means.

This apparatus is especially suitable for implementation at the IC makers facility.

In both embodiments, the results are the same: the integrated circuit package leads are rigidly held in place between two parts of a non-conductive tie bar, and the leads are not electrically connected to each other.

In the second aspect of the present invention, the metal frame surrounding and holding all of the leads together is snipped off to produce a chip package with leads located by the non-conductive tie bar. This approach is preferred because it eliminates the need to straighten the leads before applying the non-conductive tie bar. Also, it provides a great opportunity to reduce the mechanical yield loss at both the IC vendors and users facilities. In addition, it provides the opportunity to simplify or eliminate carriers.

In the first aspect of the present invention, the integrated circuit package with outwardly extending leads but no metal frame connecting them, is laid into the female part. The teeth of the mating male part fit into two spaces of the female part and press the leads thereinto. The ends of the leads extend beyond the perimeter of the mating parts. The two parts are held together by means which does not affect the integrated circuit package nor the leads. One part of a non-conductive tie bar is positioned with an adhesive side facing and contacting the leads which extend beyond the two parts. The second part of the tie bar is then fitted over the first part, so that an adhesive surface thereof meets the adhesive surface of said one part of the tie bar. This assembly is then placed into a press which presses the tie bar parts to the leads, activating the pressure sensitive adhesive. The two parts of the tie bar are then separated and the leads of the IC package are ready for bending and forming whilst rigidly held in place in the tie bar. The leads may then be bent and formed to the required positional accuracy.

In the second aspect of the present invention, the insulated circuit package is supplied with a metal frame attached to and holding all the leads surrounding the integrated circuit package. One frame of a non-conductive tie bar is laid into a die, which has protrusions for centering or aligning the tie bar material. An adhesive side of the frame faces upwards, away from the die. The integrated circuit package having the metal frame is then aligned and laid over this frame of the tie bar. The second frame of the tie bar is then aligned and laid over the first frame in such a way that its adhesive side faces downwards, towards the leads. The tie bar frame completely covers the metal frame and the parts of the leads at the areas where the leads meet the metal frame of the integrated circuit package. Pressure is then applied by a die press having four knife blades that extend through it on compression which sever the metal frame from the leads whilst snipping or removing a portion or portions of the tie bar. At the same time, the tie bar is pressed together and the adhesive activated, thus, sandwiching the leads in their proper position.

In another aspect of the present invention there is provided a method of forming an integrated circuit package assembly characterised by comprising: aligning the leads of an integrated circuit package in means having male and female teeth for aligning the leads; placing a first part of a non-conductive tie bar on the portion of the leads extending from said means; placing a second part of the tie bar on the leads; and pressing the parts of the tie bar together.

The method may further include the step of cutting away a metal frame (if there is one on the integrated circuit package).

In a yet further method of forming an integrated circuit package assembly characterised by comprising: aligning and placing, adhesive side up, a first part of a non-conductive tie bar on a die having alignment posts for locating the integrated circuit package; aligning and placing a metal frame and leads of an integrated circuit package over the first part: aligning and placing, adhesive side down, a second part of the non-conductive tie bar; and applying pressure to the parts of the tie bar and the frame.

This method may include cutting the frame from the leads.

The invention is illustrated, merely by way of example, in the accompanying drawings, in which:-

Figure 1 is an illustration of a completed non-conductive tie bar and IC package assembly;

Figure 2 is a top view of a frame of the tie bar of Figure 1;

Figure 3 is an illustration of leads from the integrated circuit package of Figure 1 connected to a part of the tie bar;

Figure 4 illustrates a first embodiment of apparatus according to the present invention;

Figure 5, consists of Figures 5A to 5C, Figure 5A being a side view of a male fixture of the apparatus of Figure 4, Figure 5B being an underside view, or bottom view of the male fixture, and Figure 5C being an enlarged view of teeth of the male fixture shown in Figure 5A;

Figure 6, consists of Figures 6A to 6D, Figure 6A being a side view of a female fixture of the apparatus of Figure 4, Figure 6B being a top view of the female fixture, Figure 6C being an enlarged view of teeth of the female fixture shown in Figure 6A, and Figure 6D being a detail of a corner shown in Figure 6B; and

Figure 7, consists of Figures 7A to 7E, Figure 7 being a side view of a second embodiment of apparatus according to the present invention, Figure 7B being a side view of an exploded tie bar and IC package assembly and an enlargement of a central portion of the apparatus shown in Figures 7A, Figure 7C being a detailed view of a base of the apparatus shown in Figure 7A, Figure 7D being a view of a top portion of Figure 7A as viewed from beneath with a top plate shown in Figure 7E removed, and Figure 7E being a view from beneath the plate at the top of Figure 7A.

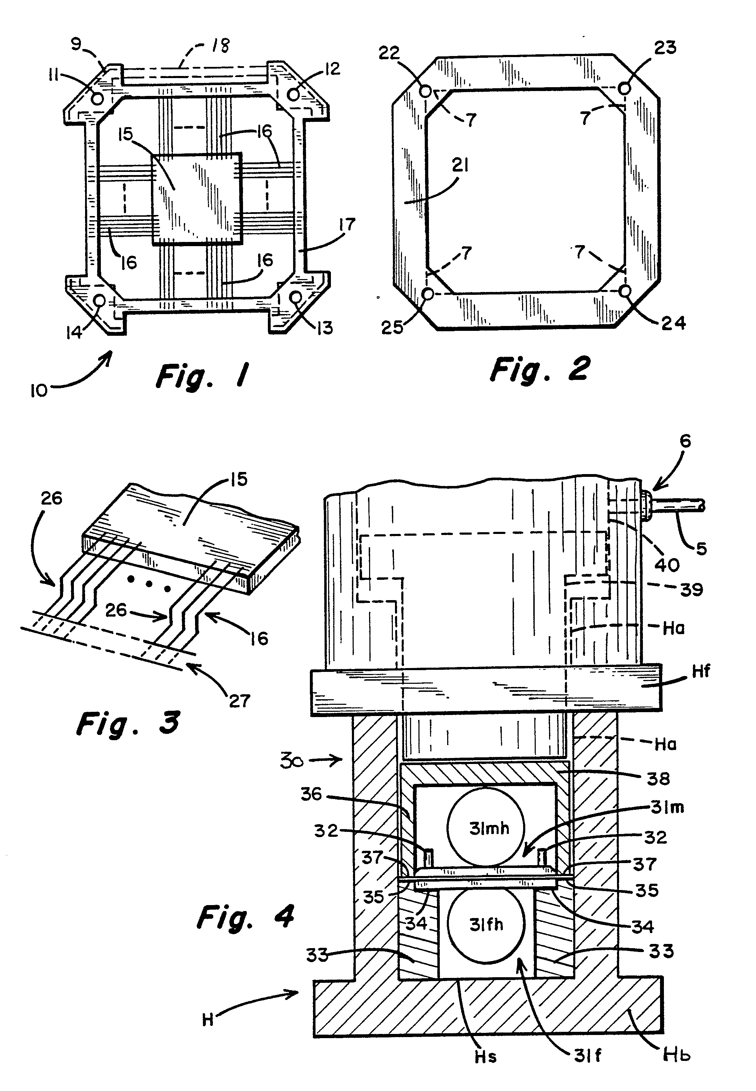

An assembly 10 including a non-conductive tie bar 17 and an integrated circuit package 15 will be described with reference to Figure 1.

The tie bar 17 is shown covering most of corners 9 of a metal frame 18. Leads 16 extend to cross bars (only one of which is shown in broken outline) of the frame 18 before they are snipped or cut away ready to form the assembly 10 as explained in detail below. The integrated circuit package 15 holds an integrated circuit chip. Holes 11,12,13,14 extend completely through the metal frame 18 and the two sides of the tie bar 17.

In Figure 2, one side of one frame 21 of the tie bar 17 is shown, having holes 22,23,24,25 therein. Dotted line corners 7 are shown to illustrate the possibility of using the frame 21 for the apparatus according to the present invention shown in Figure 4 and to show that other forms are possible.

The tie bar is generally constructed of any non-conductive material which is sufficiently rigid and which can accept adhesive. The primary use of the tie bar is to provide rigidity and to act as a substrate for holding the leads 16 in position. The rigid, non-conductive material of the tie bar may be a material commonly known as G-10 material, for example, the type of glass fibre filled epoxy used by the electronics industry, commonly as a component of circuit boards. Polyimides are among other materials that can also be used. The tie bar consists of two frames, each of which is coated on one side with pressure sensitive, high temperature acrylic adhesive. If the tie bar will not be subject to high temperature, most pressure sensitive adhesives can be used. Non-acrylic, high temperature adhesives can also be used.

Preferable materials for the tie bar are such as not to cause problems during temperature stress testing which is sometimes required. Such tests are performed on integrated circuit package assemblies to determine whether or not the part will function and be reliable in different extreme environments. Other materials can be used where high temperature testing is not required.

Reference should now be made to Figure 3, in which leads 16 from the integrated circuit package 15 are shown with bends 26 and with ends bound by a non-conductive tie bar 27. The bends 26 are made so that the leads may be fastened onto a printed circuit board (not shown). In order to do this robotically, or under automatic mechanical control, the location of the leads must remain within a narrow specified tolerance band along the entire length of the leads. Accordingly, during the bending of the leads 16, the corners of the non-conductive tie bar will be severed or cut away (along with the metal frame in some cases) so that an entire row of the leads may be bent and formed in unison.

Accordingly, one could produce four non-conductive tie bars for a square or rectangular integrated circuit package (having rows of leads on all four sides), whereby one separate non-conductive tie bar would hold the rows of leads on each side. However, it is believed that the most effective way for keeping all four sides in position is to provide a tie bar as two frames, each having adhesive on one side to form the tie bar as shown in Figure 2, holding all leads on all four sides together.

Figure 4 shows one embodiment of apparatus 30 according to the present invention. The apparatus is used when a non-conductive tie bar has to be fixed to leads of an integrated circuit package after a holding metal frame is severed from those leads. The process of producing the assembly 10 described above, may be done at two different points during its manufacture. The apparatus of Figure 4 produces the assembly 10 where the metal frame 18 has already been removed from the leads 16.

Referring first to Figure 4, the apparatus 30 can be seen to be comprised of male and female holding fixtures 31m,31f, having respective plastics handles 31mh,31fh, screw assemblies 32 for holding the male and female fixtures together, a housing assembly H, including a base Hb, a frame Hf, a stand Hs which may be part of the base Hb, a lower working surface and holding tube 33 having a base shoulder or ridge 34, and a working surface 35, an upper working tube 36, having a lower working surface 37 and a piston-engaging surface 38, and a piston 39, which is extensible downward by movement of a compressed air cylinder 40. The frame Hf, at the top, has an aperture Ha for accepting the piston 39 for engagement with the piston-engaging surface 38. Air is introduced into the cylinder at a port 6 through a compressed air tube 5.

The apparatus 30 operates by the pressing together of the surfaces 37,35 at the instance of the piston 39 by the application of compressed air into the cylinder 40. This bonds the adhesive layers of the two frames of the tie bar together on opposite sides of the rows of leads which are sandwiched between the two frames.

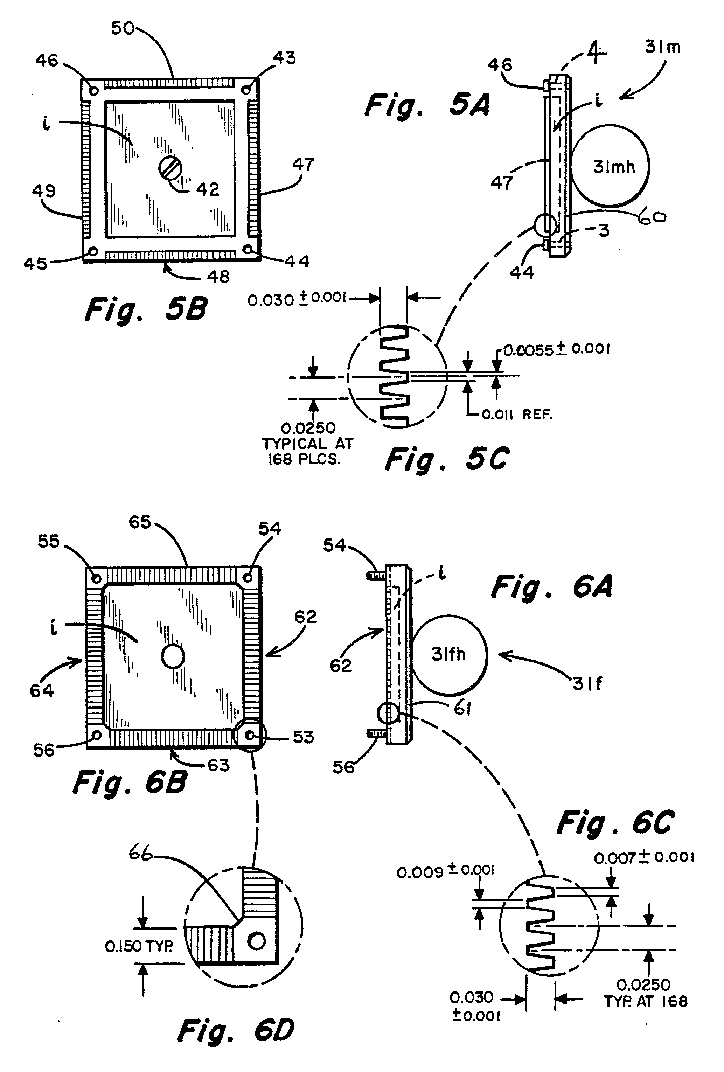

Referring to Figure 5, the male fixture 31m is shown. The handle 31mh may be a plastics knob connected by a screw 42 or other means. Posts 44,46 and threaded holes 43,45 in the male fixture 31m assure proper mating alignment of the fixtures 31f,31m. Four rows of male teeth 47,48,49,50 ring substantially the perimeter of the male fixture 31m. These teeth are shown in detail in Figure 5C with typical spacing indicated.

Referring to Figure 6, the female fixture 31f is shown. Posts 54,56 of the female fixture 31f extend into the holes 43,45 of the male fixture of Figure 5. Similarly the posts 44,46 of the male fixture 31m extend into threaded holes 53,55 of the female fixture. Thus the fixtures 31m,31f are aligned in proper orientation. Both fixtures 31m,31f have chamfered edges 60,61. The female fixtures 31f has rows of teeth 62,63,64,65 which mate with the rows of teeth of the male fixture 31m on all four sides. Note that the exposed surfaces of the teeth 62,63,64,65 of the female fixture have a wider cavity from one tooth to the next than the surface further away from the exposed surface, as also do the teeth of the male fixture. These teeth are detailed in Figure 6C, which like Figure 5C, is supplied with figures for typical spacing, the figures in both Figure 5C and Figure 6C being in mils (thousandths of an inch). An additional chamfered edge 66 is shown in Figure 6D.

The integrated circuit package 15 of Figure 1 with leads 16 but without the metal frame 18 is taken from a plastics carrier (not shown) and placed, ordinarily by hand, into the female fixture 31f. There is an indentation i (Figure 5B) for the integrated circuit package which will be complemented by a similar indentation in the male fixture. The female fixture 31f may be held by the plastics handle 31fh. The male fixture 32m is then brought into alignment with the female fixture and the fixtures are pressed together, thus forcing the leads into narrowing spaces (trapezoidal in shape) between the teeth, thus straightening and aligning the leads to some extent. Obviously, the teeth should be formed or cut to high precision spacing so that the best straightening and alignment results may be achieved. The two fixtures 31m,31f are then secured together by the screw assemblies 32 (Figure 4). The posts 54,56 may be internally threaded to accept a screw through apertures 3,4 shown in Figure 5A.

The assembled fixtures 31m,31f are then placed, female fixture downwardly because of the screw assemblies 32, onto the ridge 34. It is, of course, assumed that the apparatus 30 is in a state where the piston 39 is withdrawn into the cylinder 40 so forming a space in which to insert the assembled fixtures.

Before inserting the assembled fixtures against the ridge 34, both frames of the non-conductive tie bar are fixed to the leads 16 (Figure 1) which must extend outwardly of the assembled fixtures. In other words, the leads protruding outside the assembled fixtures on all four sides of the integrated circuit package are sandwiched between the two adhesive sides of the frames of the non-conductive tie bar. Thus, of course, the external proportions of the assembled fixtures must be less than that of the leads 16. It will be appreciated that this embodiment can be used with integrated circuit packages having a metal frame, if desired.

Alternatively, another way to mount the non-conductive tie bar is in a bonding press as follows. One frame of the non-conductive tie bar, with the adhesive facing up, is placed on the surface 35 and the female fixture 31f is inserted into it. In a further alternative, the non-conductive tie bar may be forced around the female side of the package with the adhesive side facing towards the leads which protrude from the edges of the fixtures 31m,31f. In either case, after the assembled fixtures are inserted onto the ridge 34 and the leads have therefore been placed on one frame of the non-conductive tie bar, the other frame of the non-conductive tie bar is then placed over the other and adhered thereto with the leads therebetween. This, of course, may be done outside of the apparatus 30 or inside it if the opening between the fixtures 31m,31f is wide enough to make it accessible. Also, the steps can be reversed. In any event, at this point, all that needs to be done is apply compressed air to the cylinder 40 to force the piston 39 downwards, forcing the surface 38 and the associated tube 36 to bring the surface 37 into contact with the surface 35 under pressure with the leads between the frames of the tie bar. 2800 to 5600 g/cm² (40 to 80 psi) is sufficient pressure to accomplish the desired result. A slight modification in which pressure is also brought to bear on the surface of the male fixture to align and straighten the leads is acceptable. Means other than a piston and cylinder arrangement for applying pressure are also possible.

Each frame of the non-conductive tie bar preferably has a thickness of 0.20 - 0.30 mm (8 - 12 mil).

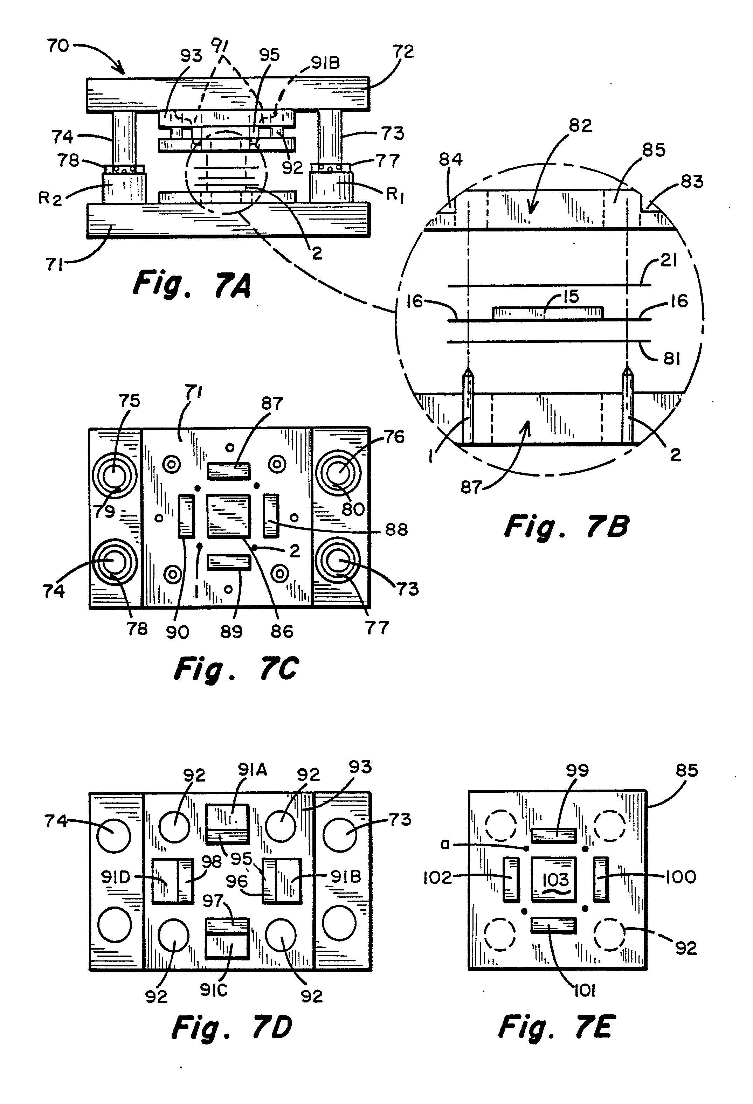

A second embodiment of apparatus 70 according to the present invention is illustrated in Figure 7. This apparatus is used when the non-conductive tie bar has to be put in place when the holding metal frame for the leads is still present.

Figure 7A is a side view of the second embodiment of the apparatus 70. The apparatus 70 includes a shoe or base 71, a shoe or top plate 72 which is movable towards the base 71 along guides 73,74,75,76. These guides may include a ball bearing sleeve 77,78,79,80. These sleeves may rest in respective outer support rings R1 to R4. Shown in Figure 7B is the integrated circuit package 15 with the leads 16 extending therefrom to each side. The frame 21 of the tie bar 17 and a second frame 81 of the tie bar are shown in side view in their pre-assembled relation to the integrated circuit package. Also shown is the cavity 82 and corners of knife blade apertures 83,84, which are part of an upper die 85. The cavity 82 avoids the application of pressure to the package 15. Also shown are locating pins 1,2, used for locating the frames 21,81 and the metal frame.

Referring now to Figure 7C, the base 71 is shown with the locations of pins 1,2, a cavity 86 corresponding to the cavity 82 and knife blade cavities 87-90.

A knife assembly 91 is shown in Figure 7A. The upper die 85 is mounted to the top plate 72 by a spring mounting 92 which is, in turn, mounted in a plate 93. The spring mounting 92 may be, for example, a coil spring surrounding a post (not shown). The knife assembly 91 is in four parts, 91A,91B,91C,91D which each have blades 95,96,97,98 (Figure 7D). They are shown mounted to the top plate 72, as is the plate 93 in Figures 7A and 7D. In Figure 7E, the upper die 85 through which the knife blades 95 to 97 pass is shown.

Apertures a provide room for the alignment posts 1,2.

The spring mounting 92 of Figure 7D connects the upper die 85 and the plate 93 together. The spring mounting functions to keep the upper die 85 and the knife blade assembly 91 separate and aligned and both have means associated with them or near them (such as a post and aperture assembly 92) to assure that the knife blades line up with holes 99 to 102. A hole 103 provides a space for the integrated circuit package to rest during the compression operation.

A cylinder (not shown) presses the top plate 72 downwards with sufficient force, for example, roughly 13300 - 36000 N (3000 - 8000 pounds force) to shear the ends of the leads from their metal frame and the associated material of the tie bar to leave the final assembled package.

The present invention as described above provides means for protecting the alignment of fine leads at fine pitches on quad and dual in-line integrated circuit packages. It therefore increases the mechanical yield of the integrated circuit packages at integrated circuit manufacturers and users facilities. Also, it improves the productivity of forming dies and provides an opportunity to simplify and/or eliminate the carriers in which the integrated circuit packages are transported. The biggest advantage is that it provides positional accuracy of the leads which makes automated integrated circuit package placement successful. Cut away portions of the leads fall away together with attached material of the non-conductive tie bar. This results in cost effective operations for maintaining the dies and eliminates the need to clean the single cut away ends of the leads. This decreases cost and increases productivity of the lead forming processes considerably.

## Claims

1. An apparatus for providing alignment to an integrated circuit package (15) having rows of leads (16) extending therefrom, characterised by comprising: a female part (31f) having on at least one edge a plurality of teeth (62-65); a male part (31m) having on at least one edge a plurality of teeth (47-50) complementary to and inter-engaging with the teeth (62-65) of the female part (31f) when the male and female parts are engaged; and attachment means (43-46, 53-56) for aligning the male and female parts whereby, in operation, co-operating teeth may hold a lead (16) therebetween.

2. Apparatus as claimed in claim 1 characterised in that a cavity (i) is provided between the male and female parts (31m, 31f) for holding the integrated circuit package when the male and female parts are engaged.

3. Apparatus as claimed in claim 1 or 2 characterised in that each of the teeth (62-65) of the female part is narrower at the top than at the bottom.

4. Apparatus as claimed in any preceding claim characterised in that the edges of the male and female parts (31m, 31f) opposite those having teeth are chamfered.

5. Apparatus as claimed in any preceding claim characterised in that a handle (31mh, 31fh) is mounted on each of the male and female parts.

6. Apparatus for compressing in the plane of the rows of leads of the integrated circuit package that portion of the leads which extends outwardly from the male and female parts (31m,31f) of the apparatus as claimed in any preceding claim, characterised by comprising a base shoulder means (34) on which either the male or female part may rest, a first working surface (35) on the base shoulder means so arranged and disposed to be coincident with the plane of the rows of workpiece leads when said male and female parts are mounted on said base shoulder means, a second working surface (37) which, in operation, is arranged and disposed to meet the first working surface (35) with portions of the leads extending beyond the male and female parts disposed therebetween, and means (39, 40) for applying pressure between said working surfaces to the portions of the leads extending outwardly of the male and female parts.

7. Apparatus for mounting a tie bar to an integrated circuit package having rows of leads extending therefrom, said leads being connected at their extremities by a frame, said apparatus being characterised by comprising: a base die means (71) having recesses (87) therein and alignment means (1,2) for locating the integrated circuit package; top means (72); alignment means (73-76) arranged to allow movement of said top means (72) towards or away from said base die (71); upper die means (85); knife means (91) mounted on the top means (72), passing through respective apertures (99-102) in said upper die means (85) and, in operation, being received in respect of apertures (87) in the base die means (71); and compression means (92) for compressibly mounting the upper die means (85) to the top means (72), the upper die means (85) having means (a) for receiving said alignment means (1,2).

8. A method of forming an integrated circuit package assembly characterised by comprising: aligning leads (16) of an integrated circuit package (15) in means (31m,31f) having male and female teeth (47-50, 62-65) for aligning the leads; placing a first part (21) of the a non-conductive bar (17) on the portion of the leads extending from said means (31m,31f); placing a second part (81) of the tie bar on the leads; and pressing the parts (21,81) of the tie bar together.

9. A method as claimed in claim 8 characterised by including the step of cutting away a metal frame (18).

10. A method of forming an integrated circuit package assembly characterised by comprising: aligning and placing, adhesive side up, a first part (21) of a non-conductive tie bar (17) on a die (71) having alignment posts (1,2) for locating an integrated circuit package (15); aligning and placing a metal frame (18) and leads (16) of an integrated circuit package (15) over the first part (21); aligning and placing, adhesive side down, a second part (81) of the non-conductive tie bar; and applying pressure to the parts of the tie bar and the frame.

11. A method as claimed in claim 10 characterised by including cutting the frame from the leads (16).

12. An integrated circuit package assembly when formed by a method as claimed in any of claims 9 to 12.

13. An apparatus for providing alignment for a workpiece integrated circuit package having rows of leads comprising: a female part having a substantially planar surface substantially containing a row of detent spaces comprising a space for each lead in each row of leads from the workpiece IC package, such that each female part row has at least one space for each available lead extending from the complementary row of leads coming from the IC package, and means for aligning connection to a male part, and the male part having a number of rows complementary to that of the female part, and each row having complementary numbers of teeth for engagement with said female part detent spaces to the number of spaces in the female part rows and having complementary attachment means for attachment with the female part, wherein said teeth and detent spaces, when engaged, may hold one lead.

14. Apparatus for compressing in the plane of the rows of leads of the workpiece that portion of the leads which extend outwardly from the teeth of the fixture of claim 13, comprising a base shoulder means on which either the male or female fixture may rest, said base shoulder means having an associated raised shoulder means so arranged and disposed to be coincident with the plane of the rows of workpiece leads when said fixture is mounted on said base shoulder means, upper functional shoulder means for fitting around a complementary other side of the fixture, having a surface arranged and disposed to meet the raised shoulder means, facing the outwardly extended portion of the leads of the workpiece when the workpiece and fixture are placed on said shoulders, and means for applying pressure to the workpiece leads to the means upper functional shoulder means and the raised shoulder means.

15. Apparatus for mounting a tie bar to a workpiece IC package having fine leads extending in rows therefrom and having said leads joined at their extremities by a frame, said apparatus comprising: substantially planar support means, a base die mounted to the support means having recesses therein and lower micro-alignment structures for aligning the workpiece with respect to the recesses, substantially planar top means, macro-alignment means connected solidly to the support means and the top means and so arranged and disposed to allow movement of said top means towards or away from said support means, but only without rotational tilting, upper die means having a knife edge with an edge for mating to and passing a complementary edge of one of said base die recesses and being mounted solidly on said top means, said knife edge facing said base die, compression plate means compressively mounted in firm non-rotatable and non-tiltable alignment to said upper die means having apertures extending therethrough to receive and pass said knife edge, and having upper micro-alignment structures for accommodation with said lower micro-alignment structures.

16. The method of forming integrated circuit package with rows of fine leads connected only by non-conductive tie bar means at one end and having their other ends connected to the integrated circuit package comprising: aligning the leads in a fixture having male and female teeth for aligning the leads; placing a mask on one side of a tie bar on the leads extending from the fixture; placing other side of the tie bar on the other side of the leads; pressing on both sides of the tie bar.

17. The method of forming an integrated circuit package with rows of fine leads connected only by non-conductive tie bar means at one end and having their other ends connected to the integrated circuit package comprising: aligning and placing, adhesive side up, a non-conductive tie bar layer on a die having alignment posts for alignment; aligning and placing the metal frame and leads of an integrated circuit workpiece over the layer; aligning and placing, adhesive side down, a second layer of non-conductive tie bar; and applying pressure to the aligned tie bar and frame; using pressure sensitive adhesive coated G-10 material and other compatible materials as non-conductive tie bar on IC packages.

**Fig. 1**

**Fig. 2**

**Fig. 3**

**Fig. 4**

Fig. 5A

Fig. 5B

Fig. 5C

0.030 ± 0.001

0.0055 ± 0.001

0.011 REF.

0.0250 TYPICAL AT 168 PLCS.

Fig. 6A

Fig. 6B

Fig. 6C

Fig. 6D

0.150 TYP.

0.009 ± 0.001

0.007 ± 0.001

0.030 ± 0.001

0.0250 TYP. AT 168

**Fig. 7A**

**Fig. 7B**

**Fig. 7C**

**Fig. 7D**

**Fig. 7E**